# EUROPEAN PATENT SPECIFICATION

(11) **EP 4 204 529 B1**
(45) Date of publication and mention of the grant of the patent: **14.05.2025**
(21) Application number: 21862752.9
(22) Date of filing: 26.08.2021
(51) Int. Cl.: C11D 1/37, C11D 1/83, C11D 1/72, C11D 3/20, C11D 3/37, C11D 11/00, C11D 1/14, C11D 1/24, C11D 3/04, H01L 21/02

(54) **POST CHEMICAL MECHANICAL PLANARIZATION (CMP) CLEANING**
REINIGUNG NACH EINER CHEMISCH-MECHANISCHEN PLANARISIERUNG (CMP)
NETTOYAGE POST-PLANARISATION MÉCANO-CHIMIQUE (CMP)

(30) Priority: 28.08.2020 US 202063071906 P
(43) Date of publication of application: 05.07.2023
(73) Proprietor: Versum Materials US, LLC, Tempe, AZ 85284 (US)
(72) Inventor: TAMBOLI, Dnyanesh, Tempe, Arizona 85284 (US); HWANG, Hee Min, Tempe, Arizona 85284 (US); YU, Jeong Yun, Tempe, Arizona 85284 (US)
(74) Representative: Merck Patent Association
(86) International application number: PCT/US2021/047780
(87) International publication number: WO 2022/047053

(56) References cited:
- WO-A2-2012/154498
- US-A1- 2007 190 770
- US-A1- 2010 167 535
- US-A1- 2011 136 717
- US-A1- 2019 390 139
- US-B1- 6 498 131
- US-B2- 7 851 426

## Description

### CROSS REFERENCE TO RELATED APPLICATIONS

This application claims priority to U.S. provisional applications 63/071,906 filed on August 28, 2020.

### BACKGROUND OF THE INVENTION

In the steps involving making of the semiconductor devices, cleaning is required at various steps to remove organic/inorganic residues. Cleaning to improve residue removal desired in semiconductor manufacturing processing, include; post-CMP (chemical mechanical planarization) cleaning, photo-resist ash residue removal, photoresist removal, various applications in back-end packaging such as pre-probe wafer cleaning, dicing, grinding etc.

A particular need for improved cleaning exists in post CMP cleaning of various structures formed by chemical mechanical planarization (CMP) process. CMP process involves polishing of one or more layers of films deposited on a wafer by pressing the wafer against a polishing pad with a CMP slurry providing the abrasive effect for material removal and provide planarity.

After the CMP step, the wafer surface contains a large number of defects, which if not cleaned from the surface would result in a defective chip as an end-product. Typical defects after a CMP process are inorganic particles, organic residues, chemical residues, reaction products on the surface due to interaction of the wafer surface with the CMP slurry and elevated levels of undesirable metals on the surface. After the polishing step, the wafer is cleaned, most commonly using a brush scrubbing process. During this process, a cleaning chemistry is dispensed on the wafer to clean the wafer. The wafer is also rinsed with deionized (DI) water before a drying process is performed.

Prior work has been done in the generally in the field of the present application include: US 2019/0390139, JP 11-181494; U.S. Pat. No. 6,440,856; U.S. Pat. No. 7,497,966 B2; U.S. Pat. No. 7,427,362 B2; U.S. Pat. No. 7,163,644 B2; PCT/US2007/061588; U.S. Pat. No. 7,396,806; U.S. Pat. No. 6,730,644; U.S. Pat. No. 7,084,097; US Patent No. 6,147,002; US 2003/0129078; and, US 2005/0067164.

US 7,851,426 B2 teaches a cleaning liquid used in cleaning of a substrate for use in semiconductor devices conducted after chemical mechanical polishing in manufacture of semiconductor devices, comprising an aqueous solution of: a polycarboxylic acid, an anionic surfactant having an aromatic ring structure in a molecule, a polymer compound having an acidic group on a side chain, and a low molecular weight polyethylene glycol, the cleaning liquid having a pH of 5 or less.

WO 2012/154498 A2 discloses a method of removing metal impurities from a substrate, said method comprising contacting the substrate comprising said metal impurities with a metal impurity removal composition to substantially remove said metal impurities from the substrate, wherein said metal impurity removal composition comprises at least one etchant, at least one chelating agent, and water.

US 2109/390139 A1 discloses a post Chemical Mechanical Planarization (CMP) cleaning composition comprising:
at least one organic acid or salts thereof selected from the group comprising dicarboxylic acid, hydroxycarboxylic acid, polycarboxylic acid, salts thereof, and combinations thereof;
a fluoride compound selected from the group comprising hydrofluoric acid, ammonium fluoride, ammonium bifluoride, quaternary ammonium fluoride and combinations thereof;
at least one polymeric additive selected from a group comprising anionic polymer, non-ionic polymer and cationic polymer and combinations thereof; and
water;
optionally
a surfactant selected from the group consisting of non-ionic surfactants, anionic surfactants, cationic surfactants, ampholytic surfactants, and mixtures thereof;
corrosion inhibitor;
biological preservative;
defoaming agent; and
pH adjusting agent;
wherein the composition has a pH of between 1 to 7.

As the technology advances, the threshold size and number of the defects that are critical for production yield of semiconductor wafers become smaller, thereby increasing the performance requirements of the post-CMP cleaners. The formulations or compositions (formulation and composition are exchangeable) in the present invention were found to be very effective in removing the residues left behind by the above described CMP polishing process.

### BRIEF SUMMARY OF THE INVENTION

Described herein are post- CMP cleaning compositions or formulations, methods, and systems for the post-CMP processing.

In one aspect, described herein is a post- CMP cleaning composition (or formulations), comprising:
at least one organic acid selected from the group consisting of oxalic acid, citric acid,
maleic acid, malic acid, malonic acid, gluconic acid, glutaric acid, ascorbic acid, formic acid, acetic acid, ethylene diamine tetraacetic acid, diethylene triamine pentaacetic acid, glycine, α-alanine, cystine, and combinations thereof or its salts;
at least two surfactants;
wherein at least one of the at least two surfactants is a first type surfactant having at least two sulfonic acid groups; and at least one of the at least two surfactants is a second type surfactant which is not the first type surfactant;
   and
water;
optionally
fluoride compound;
water soluble polymer or copolymer;
corrosion inhibitor;
biological preservative; and
pH adjusting agent;
wherein
the first type surfactant is a diphenyl disulfonic acid or its salt; the second type surfactant comprising a secondary alkane sulfonic acid with C₁₂-C₁₇ hydrophobic chain.

The p-CMP cleaning composition has a pH between 1 and 7, preferably between 2 to 6, or more preferably 3 to 6.

The compositions can be diluted with DI water 2 to 500 times at the point of use.

The second type surfactant can increase zeta potential magnitude on surface containing dielectric material.

The second type surfactant has a surface tension of < 50 dynes/cm at concentration of 0.01 wt.% in water, preferably <45 dynes/cm at concentration of 0.01 wt.% in water, or more preferably <40 dynes/cm at concentration of 0.01 wt.% in water.

The second type surfactant can reduce the contact angle on cleaning surfaces.

Surfactant concentrations of either surfactant type can be between 0.001 to 2 wt.%, preferably in the range of 0.01 to 0.75 wt.%, or more preferably between 0.01 to 0.5 wt.%.

Formulations optionally comprise a fluoride compound. Examples of fluoride compounds include hydrofluoric acid, ammonium fluoride, ammonium bifluoride, quaternary ammonium fluorides. Preferred compound is ammonium fluoride. Concentration of fluoride component in the formulation is preferably in the range of 1 to 25 wt.%, preferably between 1.25 to 20 wt.%, more preferably between 1.5 and 15, or most preferably between 2 and 10 wt.%.

Formulations may optionally comprise one or more water soluble polymers or copolymers. The polymer may be selected from but not limited to a group comprising acrylic acid- acrylamido propane sulfonic acid copolymer, poly(acrylic acid), poly(meth-acrylic acid), poly(2-acrylamido-2-methyl-1-propanesulfonic acid, carboxymethyl cellulose, methyl cellulose, hydroxypropyl methyl cellulose, poly-(1-vinylpyrroliddone-co-2-dimethylaminoethyl methacrylate), poly(sodium 4-styrenesulfonate), poly(ethylene oxide), poly(4-sytrenesulfonic acid), polyacrylamide, poly(acrylamide/acrylic acid) copolymers, and combinations thereof, and salts thereof. In preferred embodiments, the polymer is a polymer or copolymer comprising polyacrylic acid or sulfonic acid groups.

The water soluble polymers or copolymers is used in concentration ranging from 0.01 to 10 wt. %, or preferably between 0.1% to 5 wt. %.

Formulations comprise organic acids selected from a group comprising oxalic acid, citric acid, maleic acid, malic acid, malonic acid, gluconic acid, glutaric acid, ascorbic acid, formic acid, acetic acid, ethylene diamine tetraacetic acid, diethylene triamine pentaacetic acid, glycine, α-alanine, and cystine or its salts. Preferred organic acids are oxalic acid and citric acid. Organic acid concentration in the formulation may be in the range of 1 to 30 wt..%, or more preferably between 5 to 20%.

The compositions of this invention can be used for cleaning semiconductor wafers comprising at least one or more of metallic or dielectric films on the surface. Metallic films may comprise interconnect metal lines or vias comprising copper, tungsten, cobalt, aluminum, ruthenium, or their alloys. The dielectric layer can be silicon oxide films such as those derived from Tetra Ethyl Ortho Silicate (TEOS) precursors, dielectric films with one or more elements such as silicon, carbon, nitrogen, oxygen, and hydrogen. Dielectric films can be porous or non-porous or the structures may comprise air gaps.

In another aspect, described herein is a method of post Chemical Mechanical Planarization (CMP) cleaning semiconductor wafer comprising at least one surface selected from the group consisting of metallic film, dielectric film, and combinations thereof, comprising
providing the semiconductor wafer;
providing the post Chemical Mechanical Planarization (CMP) cleaning composition stated above; and
cleaning the semiconductor wafer using the post CMP cleaning composition;
wherein the metallic film is selected from the group consisting of tungsten, copper, cobalt, ruthenium, aluminum, and combinations thereof.

Wherein the method removes metallic residues selected from the group consisting of Fe, W, Ti, TiN and combinations thereof from the at least one surface.

Cleaning compositions may be used for cleaning the wafer surface with various types of cleaning techniques including but not limited to brush box cleaning, spray cleaning, megasonic cleaning, buff cleaning on a pad, single wafer spray tools, batch immersion cleaning tools, etc.

In yet another aspect, described herein is a system for post Chemical Mechanical Planarization (CMP) cleaning semiconductor wafer comprising at least one surface selected from the group consisting of metallic film, dielectric film, and combinations thereof, comprising
the semiconductor wafer; and
the post Chemical Mechanical Planarization (CMP) cleaning composition stated above;
wherein the at least one surface is in touch with the post CMP cleaning composition and the metallic film is selected from the group consisting of tungsten, copper, cobalt, ruthenium, aluminum, and combinations thereof.

In certain preferred embodiments, the cleaning composition when diluted with water can etch the dielectric films at an etch rate preferably between 0.2 to 50 Angstroms/min, or more preferably between 1 and 20 Angstroms/min., or most preferably between 1 to 10 angstroms/min.

In certain preferred embodiments, the cleaning composition when diluted with water can etch dielectric films at etch rate between 1 to 10 Angstroms/min and etch tungsten at etch rates less than 1 Angstroms/min and etch titanium nitride films at etch rates less than 5 angstroms/min at room temperature.

### BRIEF DESCRIPTION OF SEVERAL VIEWS OF THE DRAWINGS

In the accompanying drawing forming a material part of this description, there is shown:

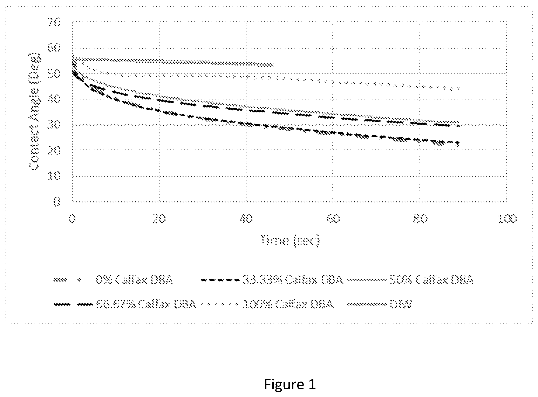

Figure 1: Contact angle as a function of time in formulations with different ratios of the two surfactants

### DETAILED DESCRIPTION OF THE INVENTION

Described and disclosed herein are compositions for cleaning in semiconductor manufacturing including post-CMP (chemical mechanical planarization) cleaning, photo-resist ash residue removal, photoresist removal, various applications in back-end packaging such as pre-probe wafer cleaning, dicing, grinding etc. The formulations are most suitable as post-CMP cleaning formulations.

Formulations of this invention are especially useful for post-CMP cleaning formulations after CMP processes including metal CMP processes wherein CMP process leads to formation of metallic interconnect structures surrounded by dielectric and dielectric CMP processes wherein one or more dielectrics are polished to form a planar surfaces or structures. Examples of metal CMP processes include but not limited to tungsten CMP, copper CMP, cobalt CMP, ruthenium CMP, aluminum CMP wherein metallic lines or vias separated by a dielectric region are formed. Examples of dielectric CMP include Shallow Trench Isolation (STI) CMP wherein silicon oxide structures are formed separated by silicon nitride regions and Inter Layer Dielectric (ILD) polish.

In one of the preferred embodiments, cleaning formulations of this invention are used for post-CMP cleaning after tungsten CMP. Formulations of this invention are especially effective for removal of metallic residues such as Fe, W, Ti and TiN that are typically formed on the wafer surface after tungsten CMP, while at the same time significantly improving organic and inorganic residue removal capabilities. Formulations of this invention are suitable for reducing the corrosion of tungsten, lowering surface roughness, and reducing galvanic corrosion between tungsten and liner materials.

Cleaning formulations are made in water as the solvent. Formulations are preferably made in a concentrate form, where in the cleaning formulation is diluted with water at the point of use in order to reduce cost of manufacturing, shipping and handling even as the formulations may be supplied as point of use formulation as well. The concentrated formulations may be diluted at point if use from 1x (1 part formulation: 1 part water by weight) to 1000x ( 1 part formulation to 1000 parts of water by weight). Concentrations provided for the additives in the cleaning formulations are for concentrates that can be diluted in the range of 1x to 1000x, or preferably between 5x to 100x or most preferably between 25 x and 75x.

The post Chemical Mechanical Planarization(CMP) cleaning composition comprising:
at least one organic acid selected from the group consisting of oxalic acid, citric acid,
maleic acid, malic acid, malonic acid, gluconic acid, glutaric acid, ascorbic acid, formic acid, acetic acid, ethylene diamine tetraacetic acid, diethylene triamine pentaacetic acid, glycine, α-alanine, cystine, and combinations thereof or its salts;
at least two surfactants;
   wherein at least one of the at least two surfactants is a first type surfactant having at least two sulfonic acid groups; and at least one of the at least two surfactants is a second type surfactant which is not the first type surfactant;
   and
water;
optionally
fluoride compound;
water soluble polymer or copolymer;
corrosion inhibitor;
biological preservative; and
pH adjusting agent wherein the composition has a pH of between 1 to 7; preferably 2 to 6, or more preferably 3 to 6; and
the first type surfactant is a diphenyl disulfonic acid or its salt; the second type surfactant comprising a secondary alkane sulfonic acid with C₁₂-C₁₇ hydrophobic chain.

Organic acids or mixtures thereof: Organic acid is chosen from oxalic acid, citric acid, maleic acid, malic acid, malonic acid, gluconic acid, glutaric acid, ascorbic acid, formic acid, acetic acid, ethylene diamine tetraacetic acid, diethylene triamine pentaacetic acid, glycine, α-alanine, cystine and combinations thereof. Polycarboxylic acid are organic acid molecules with multiple carboxylic acid groups. Polymers with monomers containing carboxylic acid groups is not considered as polycarboxylic acid in this application. Salts of the mentioned organic acids may also be used. A mixture of acids/salts may be used as well. Organic acids function to improve trace metal removals, remove organic residues, pH adjustment or reduce corrosion of metals.

In one embodiment, the cleaning composition comprises one or more organic acids selected comprising oxalic acid, citric acid, malonic acid, glycine, and α-alanine. In another embodiment of the cleaning composition the comprises a mixture of oxalic acid, citric acid, and malonic acid. In another preferred embodiment organic acid contains citric acid. In another embodiment organic acid comprise a mixture of citric acid and oxalic acid.

The cleaning chemistry may contain from 0.1 wt.% to 30 wt. % of the organic acids and or salts thereof. Preferred acid concentration ranges from 5 wt.% to 20 wt. %.

The first type of surfactant is a surfactant having diphenyl disulfonic acid or its salt.

Example of such surfactants include (a) 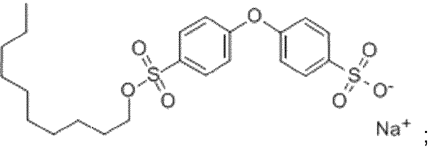 (b) 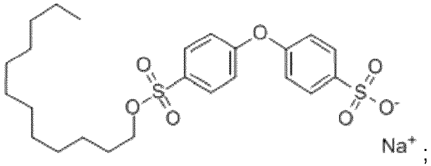 (c) 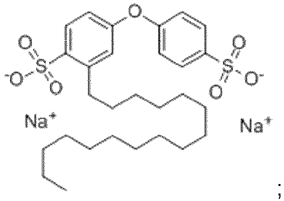 (d); 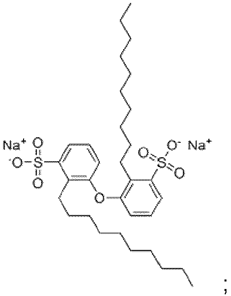 and (f)

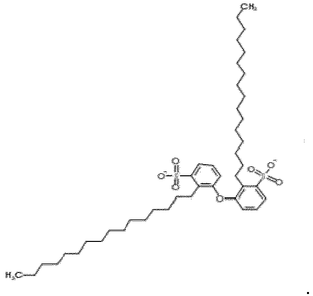

Some of the commercially available **anionic** surfactants with diphenyl disulfonic acids include Dowfax^{®} series by Dow Chemical Company : Dowfax^{™} 2A1 (structure b), Dowfax^{™} 3b2 (structure d), Dowfax^{™} C6L (structure e) and Dowfax^{™} 8390 (structure f); and Calfax^{®} series by Pilot Chemical Company: Calfax^{®} DBA-70; Calfax^{®}10L-45, Calfax^{®}16L-35, Calfax^{®}6LA-70. For the semiconductor applications, requiring high purity chemicals with very low levels of mobile ions such as sodium, surfactant solutions can be purified by any suitable technique including ion exchange to remove metal ions.

Post-CMP formulations also comprise at least one second type surfactant which does not contain diphenyl disulfonic acid group. The purpose of the second type surfactant is to provide the solution properties that are not possible with use of diphenyl disulfonic acid surfactants by themselves.

Solutions containing diphenyl disulfonic acid surfactants typically have somewhat high surface tension and higher contact angles on cleaning surfaces. The second type surfactant with suitable characteristics may also provide additional benefits in terms of surface modification of various film surfaces, particles, residues; which may improve the cleaning performance of the post-CMP cleaning solution. Therefore, a second type surfactant with better wetting properties is desired in combination with the diphenyl disulfonic acid surfactant. In the preferred embodiments, the second type surfactant has a surface tension of < 50 dynes/cm at concentration of 0.01 wt.% in water, or more preferably <45 dynes/cm at concentration of 0.01 wt.% in water or most preferably <40 dynes/cm at concentration of 0.01 wt.% in water.

Non-ionic surfactants may be chosen from a range of chemical types including but not limited to long chain alcohols, ethoxylated alcohols, ethoxylated acetylenic diol surfactants, polyethylene glycol alkyl ethers, proplylene glycol alkyl ethers, glucoside alkyl ethers, polyethylene glycol octylphenyl ethers, polyethylene glycol alkylpgenyl ethers, glycerol alkyl esters, polyoxyethylene glycol sorbiton alkyl esters, sorbiton alkyl esters, cocamide monoethanol amine, cocamide diethanol amine dodecyl dimethylamine oxide, block copolymers of polyethylene glycol and polypropylene glycol, polyethoxylated tallow amines, fluorosurfactants.

Anionic surfactants include, but are not limited to those with suitable hydrophobic tails and a anionic functional group, such as carboxylate, sulfate, sulfonate, secondary asulfonate, phosphate, bicarboxylate, bisulfate, biphosphate, such as alkoxy carboxylate, alkoxy sulfate, alkoxy phosphate, The counter ions for this type of surfactants include, but are not limited to potassium, ammonium and other positive ions. The hydrophobic group may comprise alkyl groups, aryl groups, alkoxy groups or combinations of thereof.

Cationic surfactants possess the positive net charge on major part of molecular frame. Cationic surfactants are typically halides of molecules comprising hydrophobic chain and cationic charge centers such as amines, quaternary ammonium, benzyalkonium, and alkylpyridinium ions.

Ampholytic surfactants possess both positive (cationic) and negative (anionic) charges on the main molecular chains and with their relative counter ions. The cationic part is based on primary, secondary, or tertiary amines or quaternary ammonium cations. The anionic part can be more variable and include sulfonates, as in the sultaines CHAPS (3-[(3-Cholamidopropyl)dimethylammonio]-1-propanesulfonate) and cocamidopropyl hydroxysultaine. Betaines such as cocamidopropyl betaine have a carboxylate with the ammonium. Some of the ampholytic surfactants may have a phosphate anion with an amine or ammonium, such as the phospholipids phosphatidylserine, phosphatidylethanolamine, phosphatidylcholine, and sphingomyelins.

Second type surfactant is a surfactant comprising a secondary alkane sulfonic acid with C12-C17 hydrophobic chain; such as the anionic surfactant Hostapur SAS^{®} series by Clariant. Another example of preferred second type of surfactant is Tergitol^{®} Minfoam 1x by Dow Chemicals

Formulations comprise at least one surfactant with two or more anionic groups. Without being hold to a particular theory, it may be theorized that surfactants with two or more anionic groups will likely have sufficient electrostatic field even in high ionic solutions. Therefore, the surfactant solutions will be stable against surfactant molecules collapsing into a structure that makes the solution turbid.

The molecular weight of surfactant as measured by any suitable technique such as but not limited to Gel Permeation Chromatography (GPC) may range from one hundred to over 10 million.

Surfactant concentrations of either surfactant type can be between 0.001 to 2 wt.%, preferably in the range of 0.01 to 0.75 wt.%, or more preferably between 0.01 to 0.5 wt.%.

Cleaning formulation may optionally comprise a water soluble polymeric additive. Polymer may be a homopolymer or copolymer. The polymer may be selected from but not limited to a group comprising acrylic acid-acrylamido propane sulfonic acid copolymer, poly(acrylic acid), poly(meth-acrylic acid), poly(2-acrylamido-2-methyl-1-propanesulfonic acid, carboxymethyl cellulose, methyl cellulose, hydroxypropyl methyl cellulose, poly-(1-vinylpyrroliddone-co-2-dimethylaminoethyl methacrylate), poly(sodium 4-styrenesulfonate), poly(ethylene oxide), poly(4-sytrenesulfonic acid), polyacrylamide, poly(acrylamide/acrylic acid) copolymers, and combinations thereof, and salts thereof. Molecular weight of the polymers measured by suitable technique such as GPC (gel permeation chromatography) may range from 100 to 10,000,000.

Preferred polymers are polymers comprising of sulfonic acid group, acrylic acid group or copolymers of monomers with sulfonic acid and acrylic acid groups.

Addition of the polymers to post CMP formulations with appropriate bases leads to great improvement in cleaning performance. The mechanism of cleaning improvement is still under study. One likely mechanism may be physical adsorption on surfaces, which would prevent re-deposition of removed particles and other residues. Another likely mechanism is the strong affinity towards the residues (organics) thereby increasing the driving force on lift-off during the cleaning process.

These types of polymers or mixtures thereof can be added in concentrations from 0.01 to 10 wt. % to the cleaning formulations. A preferred concentration range is between 0.1% to 5 wt. %. The formulations may be diluted by a by a factor of 2 to 500 at point of use through addition of solvent, such as water. Alternatively, the formulations may be supplied in diluted form for the direct use without the dilution at the point of use.

Formulations also optionally comprise a fluoride compound. Examples of fluoride compounds include hydrofluoric acid, ammonium fluoride, ammonium bifluoride, quaternary ammonium fluorides. Preferred compound is ammonium fluoride. Concentration of fluoride component in the formulation is between 1 to 25 wt.%, preferably between 1.25 to 20 wt.%, more preferably between 1.5 and 15, or most preferably between 2 and 10 wt.%; wherein the formulation is diluted 2 to 500 times at the point of use.

Inorganic acids, such as nitric acid, sulfonic acid, or phosphoric acid can be used as pH adjusting agent. Inorganic base, such as ammonia hydroxide, potassium hydroxide or sodium hydroxide, organic bases such as quaternary ammonium hydroxides, various amine compounds can also be used for pH adjusting agent.

pH of the formulation is between 1 and 7, preferably between 2 and 6 or most preferably between 3 and 6.

Formulations can be diluted with DI water 2 to 500 times at the point of use.

For post-CMP cleaning formulations, there may be additional components present which help with cleaning performance. Common types of additives include the following.

The cleaning chemistry may optionally contain chelating agent.

Since a chelating agent may be more selective with regard to one metal ion over another, a plurality of chelating agents or salts thereof are used in the compositions described herein. It is believed that these chelating agents may bind to metal ion contaminants on the substrate surface and dissolve them into the composition. Further, in certain embodiments, the chelating agent should be able to retain these metal ions in the composition and prevent the ions from re-depositing on the substrate surface. Examples of suitable chelating agents that may be used include, but are not limited to: ethylenediaminetetracetic acid (EDTA), N-hydroxyethylethylenediaminetriacetic acid (NHEDTA), nitrilotriacetic acid (NTA), diethylklenetriaminepentacetic acid (DPTA), ethanoldiglycinate, citric acid, gluconic acid, oxalic acid, phosphoric acid, tartaric acid, methyldiphosphonic acid, aminotrismethylenephosphonic acid, ethylidene-diphosphonic acid, 1-hydroxyethylidene-1,1-diphosphonic acid, 1-hydroxypropylidene-1,1-diphosphonic acid, ethylaminobismethylenephosphonic acid, dodecylaminobismethylenephosphonic acid, nitrilotrismethylenephosphonic acid, ethylenediaminebismethylenephosphonic acid, ethylenediaminetetrakismethylenephosphonic acid, hexadiaminetetrakismethylenephosphonic acid, diethylenetriaminepentamethylenephosphonic acid and 1,2-propanediaminetetetamethylenephosphonic acid or ammonium salts, organic amine salts, maronic acid, succinic acid, dimercapto succinic acid, glutaric acid, maleic acid, phthalic acid, fumaric acid, polycarboxylic acids such as tricarbaryl acid, propane-1,1,2,3-tetracarboxylic acid, butane-1,2,3,4-tetracarboxylic acid, pyromellitic acid, oxycarboxylic acids such as glycolic acid, .beta.-hydroxypropionic acid, citric acid, malic acid, tartaric acid, pyruvic acid, diglycol acid, salicylic acid, gallic acid, polyphenols such as catechol, pyrogallol, phosphoric acids such as pyrophosphoric acid, polyphosphoric acid, heterocyclic compounds such as 8-oxyquinoline, and diketones such as .alpha.-dipyridyl acetylacetone.

The chelating agent may be used at a concentration ranging from 0.01 wt..% to 30 wt..%

The cleaning chemistry may optionally contain defoaming compounds. The defoamer or an anti-foaming agent is a chemical additive that reduces and hinders the formation of foam in the formulation. The terms anti-foam agent and defoamer are often used interchangeably. Commonly used agents are insoluble oils, polydimethylsiloxanes and other silicones, certain alcohols, stearates and glycols, certain surfactants such as a combination of polyether surfactant and a polyhydric alcohol fatty acid ester, Surfynol MD20 surfactant from Evonik Chemicals. The defoaming compound may be used in a concentration ranging from 0.00001 wt..% to 0.01 wt..% in the cleaning formulation.

The cleaning chemistry may optionally contain biocide. CMP formulations may also comprise additives to control biological growth such as biocides. Some of the additives to control biological growth are disclosed in U.S. Pat. No. 5,230,833 (Romberger et al.) and U.S. patent application Publication No. 2002/0025762. Biological growth inhibitors include but are not limited to tetramethylammonium chloride, tetraethylammonium chloride, tetrapropylammonium chloride, alkylbenzyldimethylammonium chloride, and alkylbenzyldimethylammonium hydroxide, wherein the alkyl chain ranges from 1 to about 20 carbon atoms, sodium chlorite, sodium hypochlorite, isothiazolinone compounds such as methylisothiazolinone, methylchloroisothiazolinone and benzisothiazolinone. Some of the commercially available preservatives include KATHON^{™} and NEOLENE^{™} product families from Dow Chemicals and Preventol^{™} family from Lanxess.

The preferred biocides are isothiozilone compounds such as methylisothiazolinone, methylchloroisothiazolinone and benzisothiazolinone

Formulations may comprise biocide ranging from 0.0001 wt. % to 0.10 wt. %, preferably from 0.0001 wt. % to 0.005 wt. %, and more preferably from 0.0002 wt. % to 0.0025 wt. % to prevent bacterial and fungal growth during storage.

Chemistries may be used in a variety of cleaning applications, which demand removal of residues from a surface. The residues may be inorganic or organic in nature. Examples of processes, where formulations containing these polymers may be effective, include; post-CMP cleaning, photo-resist ash residue removal, photoresist removal, and various applications in back-end packaging, such as; pre-probe wafer cleaning, dicing, grinding etc. as well as cleaning of wafers for photovoltaic applications.

The compositions of this invention are especially suitable for cleaning semiconductor wafers comprising at least one or more of metallic or dielectric films on the surface. Metallic films may comprise interconnect metal lines or vias comprising copper, tungsten, cobalt, aluminum, ruthenium, Germanium-Antimony-Tellurium (GST), or their alloys. The dielectric layer can be silicon oxide films such as those derived from Tetra Ethyl Ortho Silicate (TEOS) precursors, dielectric films with one or more elements such as silicon, carbon, nitrogen, oxygen, and hydrogen. Dielectric films can be porous or non-porous or the structures may comprise air gaps.

Cleaning compositions may be used for cleaning the wafer surface with various types of cleaning techniques including but not limited to brush box cleaning, spray cleaning, megasonic cleaning, buff cleaning on a pad, single wafer spray tools, batch immersion cleaning tools, etc. or a combination of such methods.

In certain preferred embodiments, the cleaning composition when diluted with water can etch the dielectric films at an etch rate preferably between 0.2 to 50 Angstroms/min, or more preferably between 1 and 20 Angstroms/min at room temperature.

In some preferred embodiments, room temperature etch rates of metallic films (tungsten and titanium nitride) is very low, preferably less than 10 Angstroms/min, or more preferably less than 5 Angstroms/min or most preferably less than 2 Angstroms/min

Formulations of this invention are especially suitable for post-CMP cleaning application for tungsten. Tungsten CMP results in metallic residues comprising W, Ti, and Fe, which can form invisible residues on the dielectric surface. These residues can increase leakage currents and reduce the effectiveness of the semiconductor devices. Titanium particularly is a very difficult to remove from the wafer surface as titanium is generally stable as solid oxide phase over a broad pH range. Formulations of this invention because of suitable organic acids and the dielectric etching capability are able to effectively remove the titanium residues and improve electrical performance of the devices.

It is desirable that the post-CMP cleaning solutions have low turbidity. Having high turbidity leads to interference in the measurement of number of particles present in the solution, which is critical for controlling the quality of the post-CMP cleaning solutions. Turbidity can be measured using any suitable optical technique. Turbidity values are typically measured by measurement of amount of light that is scattered by material in the solution when the light is shined through the solution sample. Higher the intensity of scattered light, the higher the turbidity. One of the commonly used units for turbidity measurement is Nephelometric Turbidity Unit (NTU ). It is desirable that the post-CMP cleaning solution has a turbidity of less than 5 NTU, preferably less than 2.5 NTU, more preferably less than 2.0 NTU, or most preferably less than 1 NTU.

In another aspect, described herein is a method of post Chemical Mechanical Planarization (CMP) cleaning semiconductor wafer comprising at least one surface selected from the group consisting of metallic film, dielectric film, and combinations thereof, comprising
providing the semiconductor wafer;
providing the post Chemical Mechanical Planarization (CMP) cleaning composition stated above; and
cleaning the semiconductor wafer using the post CMP cleaning composition;
wherein the metallic film is selected from the group consisting of tungsten, copper, cobalt, ruthenium, aluminum, and combinations thereof.

Wherein the method removes metallic residues selected from the group consisting of Fe, W, Ti, TiN and combinations thereof from the at least one surface.

In yet another aspect, described herein is a system for post Chemical Mechanical Planarization (CMP) cleaning semiconductor wafer comprising at least one surface selected from the group consisting of metallic film, dielectric film, and combinations thereof, comprising
the semiconductor wafer; and
the post Chemical Mechanical Planarization (CMP) cleaning composition stated above;
wherein the at least one surface is in touch with the post CMP cleaning composition and the metallic film is selected from the group consisting of tungsten, copper, cobalt, ruthenium, aluminum, and combinations thereof.

In certain preferred embodiments, the cleaning composition when diluted with water can etch dielectric films at etch rate between 1 to 10 Angstroms/min and etch tungsten at etch rates less than 1 Angstroms/min and etch titanium nitride films at etch rates less than 5 angstroms/min at room temperature.

The cleaning compositions, methods and systems described herein will be illustrated in more detail with reference to the following examples, but it should be understood that it is not deemed to be limited thereto.

### Working Examples

### Example 1

Concentrate formulations were made as shown in Table 1. Formulations 1-4 are comparative.

The formulations were diluted 1 part formulation to 49 parts water by weight.

Zeta potentials on tungsten and TEOS surfaces were measured using Surface Zeta Potential cell on Zetasizer Nano tool ( Malvern Instruments Inc.117 Flanders Road Westborough MA 01581-1042) by adding high purity silica particles as trace particles.

Surfactants were used in the acid form.

The data shows that Calfax^{®} DBA-70 by Pilot Chemical Company, 9075 Centre Pointe Drive, Suite 400, West Chester, OH 45069; which is a diphenyl disulfonic acid comprising C₁₂ hydrophobic chain is very effective for increasing the zeta potential magnitude on tungsten surface.

On the other hand, the second type surfactant (not a diphenyl disulfonic acid surfactant) Hostapur SAS^{®} by Clariant (anionic surfactant) which is a secondary alkane sulfonic acid with C₁₂-C₁₇ hydrophobic chain, is more effective to increase zeta potential magnitude on TEOS surface.

**Table 1**

| **Formulation Number** | **1** | **2** | **3** | **4** | **5** |
|---|---|---|---|---|---|
| Citric Acid (wt.%) | 2.8 | 2.8 | 2.8 | 2.8 | 2.8 |
| Malonic Acid (wt.%) | 1.4 | 1.4 | 1.4 | 1.4 | 1.4 |
| Oxalic Acid (wt.%) | 2.8 | 2.8 | 2.8 | 2.8 | 2.8 |
| Polyacrylic Acid (wt.%) (Mol. Wt. 2000-20000) | 0 | 0.5 | 0.5 | 0.5 | 0.5 |
| Calfax^{®} DBA-70 (wt.%) | 0 | 0 | 0.2 | 0 | 0.2 |
| Hostapur ^{®}SAS (wt.%) | 0 | 0 | 0 | 0.375 | 0.375 |
| Ammonium Hydroxide (wt.%) | 0.8 | 0.8 | 0.8 | 0.8 | 0.8 |
| Water | Balance | Balance | Balance | Balance | Balance |
| pH | 2.55 | 2.55 | 2.55 | 2.55 | 2.55 |
| Tungsten Zeta potential (mV) | -0.65 | 2.47 | -21.4 | -10.2 | -24.3 |
| TEOS Zeta Potential (mV) | -4.16 | 1.74 | 1.05 | -21.2 | -20.3 |

Surface zeta potential change by surfactant strongly indicates ability to modify the film surfaces by adsorption and making them easy to clean. The increase in the magnitude of negative zeta potential is likely associated with anionic groups in the surfactant. pH of 2.55 was used to measure zeta potential change without the use of ammonium fluoride.

A combination of two surfactants one of which is diphenyl disulfonic acid form allows strong surface modification of both metallic (tungsten in this example) and dielectric (TEOS in this example) which is crucial for cleaning patterned wafers which contain both metallic and dielectric surfaces.

### Example 2

Different formulations were made by adding both Calfax^{®} DBA-70 and Hostapur^{®} SAS surfactants to formulation 1 in Table 1.

Formulation 1 was first diluted 1 part formulation with 49 parts water by weight to make 50x dilution.

Surfactants were then added to the dilution. Total surfactant concentration in the dilution was fixed at 60 ppm.

The fraction of individual surfactant in the surfactant mixture was varied between 0 to 100% of the total surfactant amount.

A hydrophobic tungsten surface was created by holding the tungsten film at 50°C for 4 days.

Contact angles were measured on the tungsten film surface as a function of time after placing the drop on the film. Measured contact angles are shown in figure 1.

As evident from this figure, increasing the Calfax^{®} DBA70 surfactant had a little impact on reducing the contact angles. The second type surfactant Hostapur^{®} SAS is capable of lowering the contact angle very effectively (as shown in the curve with 0% Calfax DBA). By addition of including Calfax^{®} DBA surfactant up to 33% of the total surfactant mixture, the contact angle on tungsten can still be reduced substantially.

### Example 3

Formulation 6 was prepared as described in table 2.

**Table 2**

| **Formulation Number** | **6** |
|---|---|
| Citric Acid (wt.%) | 2.8 |
| Malonic Acid (wt.%) | 1.4 |
| Oxalic Acid (wt.%) | 2.8 |
| Ammonium Fluoride (wt.%) | 2.45 |
| Water | Balance |
| pH | 3-4 |

Surfactants at various concentrations were added in Formulation 6 as shown in Table 3.

In Table 3, Surfactant 1 was Dowfax^{®} series by Dow Chemical Company. Surfactant 1 were diphenyl disulfonic acid surfactants with different structures.

The second type surfactant, Surfactants 2 Hostapur^{®} SAS in Table 3 was not a diphenyl disulfonic acid surfactant.

Stability of the formulations was measured by turbidity measurement using Hatch turbidity testing tool. Table 3 summarizes the turbidity data. Formulation 6 is a reference formulation, formulations 7, 16, 17 and 19 are comparative formulations.

Surfactants 2 Hostapur^{®} SAS addition to formulation 6 results in very high turbidity (29.6) as evident from turbidity data for formulation 7.

However, adding the diphenyl disulfonic acid surfactants 1, the turbidity went down.

For most solutions containing these surfactants have turbidity less than 2NTU, which is indicative of a clear transparent solution. This shows the unexpected ability of the diphenyl disulfonic acid surfactants to solubilize the second surfactant.

**Table 3**

| **Formulation#** | **Surfactant 1** | **Surfactant 2** | **Surfactant 1 wt.%** | **Surfactant 2 wt.%** | **Turbidity (NTU)** |
|---|---|---|---|---|---|
| 6 | | | 0 | 0 | 0.261 |
| 7 | | Hostapur^{®} SAS | 0 | 0.375 | 29.5 |
| 8 | Dowfax^{®} 2A1 | Hostapur^{®} SAS | 0.01 | 0.375 | 26.2 |
| 9 | Dowfax^{®} 2A1 | Hostapur^{®} SAS | 0.05 | 0.375 | 1.58 |
| 10 | Dowfax^{®} 2A1 | Hostapur^{®} SAS | 0.075 | 0.375 | 1.32 |
| 11 | Dowfax^{®} 2A1 | Hostapur^{®} SAS | 0.1 | 0.375 | 1.1 |
| 12 | Dowfax^{®} 2A1 | Hostapur^{®} SAS | 0.15 | 0.375 | 0.92 |
| 13 | Dowfax^{®} 2A1 | Hostapur^{®} SAS | 0.2 | 0.375 | 0.633 |
| 14 | Dowfax^{®} 2A1 | Hostapur^{®} SAS | 0.3 | 0.375 | 0.673 |
| 15 | Dowfax^{®} 8390 | Hostapur^{®} SAS | 0.3 | 0.375 | 0.677 |
| 16 | Dowfax^{®} 8390 | Hostapur^{®} SAS | 0.3 | 0 | 0.665 |
| 17 | Dowfax^{®} 8390 | Hostapur^{®} SAS | 0 | 0.375 | 26.5 |
| 18 | Dowfax^{®} C6L | Hostapur^{®} SAS | 0.3 | 0.375 | 0.867 |
| 19 | Dowfax^{®} C6L | Hostapur^{®} SAS | 0.3 | 0 | 0.317 |

### Example 4 (comparative)

Formulation 20 was prepared as described in table 4.

**Table 4**

| **Formulation Number** | **20** |
|---|---|
| Citric Acid (wt.%) | 3 |
| Benzene Sulfonic Acid (wt.%) | 3 |
| Oxalic Acid (wt.%) | 3 |
| Ammonium Fluoride (wt.%) | 2.5 |
| Water | Balance |
| pH | 3-4 |

To this formulation, surfactants at various concentrations (wt.%) were added as shown in Table 5.

Turbidity measurement of various surfactant combinations was performed using Hatch turbidity testing tool.

**Table 5**

| Formulation | Polyoxyethylene (20) sorbitan monolaurate (Tween 20) | Polyoxyethylene (40) sorbitan monolaurate (Tween 40) | PEG(80) sorbitan monolaurate | Pluronic 17R | Calfax^{®} DBA-40 | Turbidity (NTU) |
|---|---|---|---|---|---|---|
| 21 | 0.1 | | | | | 0.97 |
| 22 | 0.1 | | | | 0.05 | 0.76 |
| 23 | 0.1 | | | | 0.1 | 0.75 |
| 24 | | 0.1 | | | | 1.65 |
| 25 | | 0.1 | | | 0.05 | 0.82 |
| 26 | | 0.1 | | | 0.1 | 0.93 |
| 27 | | | 0.1 | | | 1.2 |
| 28 | | | 0.1 | | 0.05 | 0.96 |
| 29 | | | 0.1 | | 0.1 | 0.89 |
| 30 | | | | 0.1 | | 1.53 |
| 31 | | | | 0.1 | 0.05 | 0.86 |
| 32 | | | | 0.1 | 0.1 | 0.64 |

Table 5 summarizes the turbidity data.

Calfax DBA-40 is C₁₂ (branched) Diphenyl Disulfonic Acid surfactant available from Pilot Chemical Company.

Other surfactants were purchased from Millipore Sigma (400 Summit Drive Burlington 01803 United States).

It is evident from the table that the addition of Diphenyl Disulfonic Acid surfactant surfactants is able to reduce the turbidity for post-CMP cleaning solutions containing a wide range of surfactants.

### Example 5 (comparative)

Formulations were made as per the table 6 and tested for turbidity.

Tergitol^{™}Min Foam 1x is a surfactant containing ethylene oxide and propylene oxide groups manufactured by Dow Chemicals.

**Table 6**

| wt.% | 33 (Comparative) | 34 | 35 | 36 | 37 | 38 |
|---|---|---|---|---|---|---|
| Citric Acid | 2.8 | 2.8 | 2.8 | 2.8 | 15 | 15 |
| Oxalic Acid | 2.8 | 2.8 | 2.8 | 2.8 | 2 | 2 |
| Malonic Acid | 1.4 | 1.4 | 1.4 | 1.4 | | |
| Ammonium Polyacrylate ( MW 2000-20000) | 0.5 | 0.5 | 0.5 | 0.5 | 0.5 | 0.5 |
| Tergitol Min-Foam 1x | 0.1 | 0.1 | 0.15 | 0.2 | 0.1 | 0.1 |
| Calfax DBA-40 | | 0.1 | 0.1 | 0.1 | 0.2 | 0.15 |
| Ammonium Fluoride | 4.9 | 4.9 | 4.9 | 4.9 | 7 | 7 |
| Turbidity (NTU) | >10 | 0.636 | 0.99 | 1.22 | 0.921 | 1.25 |

Table 6 summarizes the turbidity data.

It is evident from the table that the addition of Diphenyl Disulfonic Acid surfactant Calfax DBA-40 is able to reduce the turbidity for post-CMP cleaning solutions. All solutions containing Calfax DBA-40 have turbidity less than 2NTU, which is indicative of a clear transparent solution. This again shows the unexpected ability of the diphenyl disulfonic acid surfactants to solubilize Tergitol Min-Foam 1x.

### Example 6

Surface tension of various surfactants was measured using sessile drop method with ramé-hart 590 tool (manufactured by ramé-hart instrument co. 19 Route 10 East, Suite 11Succasunna, NJ 07876 USA). The tool uses contour fitting algorithm, and the profile coordinates of the contour of the drop to calculate the surface tension of the liquid. Table 6 provides the surface tension with various surfactants at 0.01% concentration in water.

**Table 7**

| | Concentration (wt.%) | Surface Tension (dynes/cm) |
|---|---|---|
| Calfax DBA -40 | 0.01 | 55.4 |
| Tergitol Minfoam 1x | 0.01 | 39.4 |
| Hostapur SAS | 0.01 | 41.0 |
| Tergitol 15-S-7 | 0.01 | 36.9 |
| Tergitol 15-S-9 | 0.01 | 41.6 |

It is evident from table 7, diphenyl disulfonic acid surfactant as represented by Calfax DBA-40 has high surface tension value at a given concentration. A second surfactant with low surface tension value is needed to reduce the surface tension of the cleaning solution.

## Claims

1. A post Chemical Mechanical Planarization (CMP) cleaning composition comprising:
at least one organic acid selected from the group consisting of oxalic acid, citric acid, maleic acid, malic acid, malonic acid, gluconic acid, glutaric acid, ascorbic acid, formic acid, acetic acid, ethylene diamine tetraacetic acid, diethylene triamine pentaacetic acid, glycine, α-alanine, cystine, and combinations thereof or its salts;
at least two surfactants;
wherein at least one of the at least two surfactants is a first type surfactant having at least two sulfonic acid groups; and at least one of the at least two surfactants is a second type surfactant which is not the first type surfactant;
and
water;
optionally:
fluoride compound;
water soluble polymer or copolymer;
corrosion inhibitor;
biological preservative; and
pH adjusting agent,
wherein the composition has a pH of between 1 to 7; preferably 2 to 6, or more preferably 3 to 6; and
the first type surfactant is a diphenyl disulfonic acid or its salt; the second type surfactant comprising a secondary alkane sulfonic acid with C₁₂-C₁₇ hydrophobic chain.

2. The post CMP cleaning composition of Claim 1, wherein the first type surfactant has a structure selected from the group consisting of: 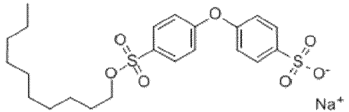 (a); 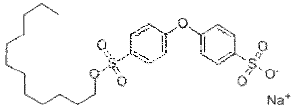 (b) ; 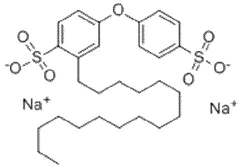 (c) ; 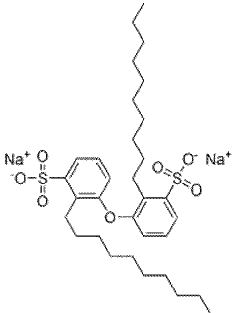 (d); ; and (f)

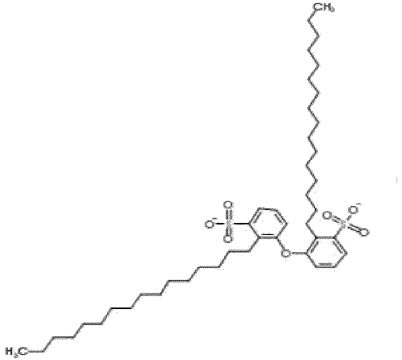

3. The post CMP cleaning composition of Claim 1, wherein the second type surfactant has a surface tension of < 50 dynes/cm, preferably of <45 dynes/cm at concentration of 0.01 wt.% in water.

4. The post CMP cleaning composition of Claim 1, wherein the fluoride compound is selected from the group consisting of hydrofluoric acid, ammonium fluoride, ammonium bifluoride, quaternary ammonium fluorides, and combinations thereof; the water soluble polymer comprises a group selected from the group consisting of sulfonic acid group, acrylic acid group, and combinations thereof; and the water soluble copolymer comprises monomers having a group selected from the group consisting of sulfonic acid group, acrylic acid group, and combinations thereof;
the corrosion inhibitor is selected from the group consisting of oligomer or polymer comprising of ethyleneimine, propyleneimine, polyethyleneimine (PEI), and combinations thereof; wherein molecular weight of the oligomer or polymer ranges from between 500 and 15000;
the biological preservative is selected from the group consisting of: tetramethylammonium chloride; tetraethylammonium chloride; tetrapropylammonium chloride; alkylbenzyldimethylammonium chloride; alkylbenzyldimethylammonium hydroxide; sodium chlorite; sodium hypochlorite; isothiazolinone compound selected from the group consisting of methylisothiazolinone, methylchloroisothiazolinone, benzisothiazolinone and combinations thereof; and combinations thereof; and/or the pH adjusting agent is selected from the group consisting of inorganic acid, nitric acid, sulfonic acid, or phosphoric acid; inorganic base selected from the group consisting of ammonium hydroxide, potassium hydroxide or sodium hydroxide; and organic base selected from the group consisting of quaternary ammonium hydroxide, and amine compound.

5. The post CMP cleaning composition of Claim 1, wherein the fluoride compound is ammonium fluoride.

6. The post CMP cleaning composition of Claim 1, wherein the water soluble polymer or copolymer is selected from the group consisting of acrylic acid-acrylamido propane sulfonic acid copolymer, poly(acrylic acid), poly(meth-acrylic acid), poly(2-acrylamido-2- methyl-1-propanesulfonic acid, carboxymethyl cellulose, methyl cellulose, hydroxypropyl methyl cellulose, poly-(1-vinylpyrroliddone-co-2-dimethylaminoethyl methacrylate), poly(sodium 4-styrenesulfonate), poly(ethylene oxide), poly(4-sytrenesulfonic acid), polyacrylamide, poly(acrylamide/acrylic acid) copolymer, and combinations thereof; wherein molecular weight of the water soluble polymer or copolymer ranges from 100 to 10,000,000.

7. The post CMP cleaning composition of Claim 1, wherein the composition has turbidity less than 2.5 NTU, preferably 2 NTU, or more preferably 1 NTU.

8. The post CMP cleaning composition of Claim 1, wherein the composition comprises at least one organic acid selected from the group consisting of oxalic acid, citric acid, malonic acid, and combinations thereof; and optionally the fluoride compound selected from the group consisting of hydrofluoric acid, ammonium fluoride, ammonium bifluoride, quaternary ammonium fluorides, and combinations thereof; and optionally the water soluble polymer comprising acrylic acid group or the water soluble copolymer comprising monomers having acrylic acid group.

9. A method of post Chemical Mechanical Planarization (CMP) cleaning semiconductor wafer comprising at least one surface selected from the group consisting of metallic film,
dielectric film, and combinations thereof, comprising:
providing the semiconductor wafer;
providing the post Chemical Mechanical Planarization (CMP) cleaning composition of any one of claims 1 to 9; and
cleaning the semiconductor wafer using the post CMP cleaning composition;
wherein the metallic film is selected from the group consisting of tungsten, copper, cobalt, ruthenium, aluminum, and combinations thereof.

10. The method of post Chemical Mechanical Planarization (CMP) cleaning of claim 9; where the method removes metallic residues selected from the group consisting of Fe, W, Ti, TiN and combinations thereof from the at least one surface.

11. The method of post Chemical Mechanical Planarization (CMP) cleaning of claim 9, wherein the composition is diluted with water 2 to 500 times at point of use.

12. A system for post Chemical Mechanical Planarization (CMP) cleaning semiconductor wafer comprising at least one surface selected from the group consisting of metallic film, dielectric film, and combinations thereof, comprising:
the semiconductor wafer; and
the post Chemical Mechanical Planarization (CMP) cleaning composition of any one of claims 1 to 8; and
wherein the at least one surface is in touch with the post CMP cleaning composition and the metallic film is selected from the group consisting of tungsten, copper, cobalt, ruthenium, aluminum, and combinations thereof.

## Patentansprüche

1. Zusammensetzung für die Reinigung nach chemisch-mechanischer Planarisierung (CMP), enthaltend:
mindestens eine organische Säure, die ausgewählt ist aus der Gruppe bestehend aus Oxalsäure, Zitronensäure, Maleinsäure, Äpfelsäure, Malonsäure, Gluconsäure, Glutarsäure, Ascorbinsäure, Ameisensäure, Essigsäure, Ethylendiamin-tetraessigsäure, Diethylentriamin-pentaessigsäure, Glycin, α-Alanin, Cystin und Kombinationen davon oder ihre Salze;
mindestens zwei Tenside;
wobei mindestens eines der mindestens zwei Tenside ein erster Tensidtyp mit mindestens zwei Sulfonsäuregruppen ist; und mindestens eines der mindestens zwei Tenside ein zweiter Tensidtyp ist, der nicht der erste Tensidtyp ist;
und
Wasser;
gegebenenfalls:
Fluoridverbindung;
wasserlösliches Polymer oder Copolymer;
Korrosionshemmer;
biologisches Konservierungsmittel; und
pH-Regulator,
wobei die Zusammensetzung einen pH von zwischen 1 bis 7; vorzugsweise 2 bis 6 oder stärker bevorzugt 3 bis 6 aufweist; und
der erste Tensidtyp eine Diphenyl-disulfonsäure oder ihr Salz ist; wobei der zweite Tensidtyp eine sekundäre Alkansulfonsäure mit hydrophober C₁₂-C₁₇-Kette umfasst.

2. Zusammensetzung für die Reinigung nach CMP nach Anspruch 1, wobei der erste Tensidtyp eine Struktur aufweist, die ausgewählt ist aus der Gruppe bestehend aus: 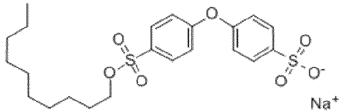 (a) 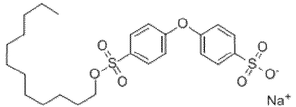 ; (b) ; 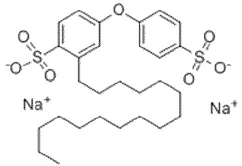 (c) ; 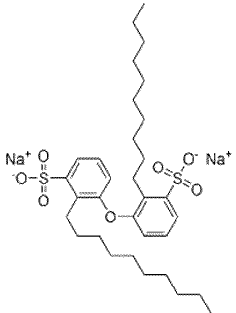 (d) ; und (f)

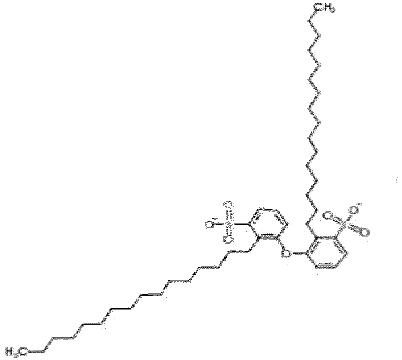

3. Zusammensetzung für die Reinigung nach CMP nach Anspruch 1, wobei der zweite Tensidtyp bei einer Konzentration von 0,01 Gew.-% in Wasser eine Oberflächenspannung von < 50 Dyn/cm, vorzugsweise von <45 Dyn/cm aufweist.

4. Zusammensetzung für die Reinigung nach CMP nach Anspruch 1, wobei die Fluoridverbindung ausgewählt ist aus der Gruppe bestehend aus Fluorwasserstoffsäure, Ammoniumfluorid, Ammoniumbifluorid, quaternären Ammoniumfluoriden und Kombinationen davon; das wasserlösliche Polymer eine Gruppe enthält, die ausgewählt ist aus der Gruppe bestehend aus Sulfonsäuregruppe, Acrylsäuregruppe und Kombinationen davon; und das wasserlösliche Copolymer Monomere mit einer Gruppe enthält, die ausgewählt ist aus der Gruppe bestehend aus Sulfonsäuregruppe, Acrylsäuregruppe und Kombinationen davon;
der Korrosionshemmer ausgewählt ist aus der Gruppe bestehend aus Oligomer oder Polymer enthaltend Ethylenimin, Propylenimin, Polyethylenimin (PEI) und Kombinationen davon; wobei das Molekulargewicht des Oligomers oder Polymers im Bereich zwischen 500 und 15000 liegt;
das biologische Konservierungsmittel ausgewählt ist aus der Gruppe bestehend aus: Tetramethylammoniumchlorid; Tetraethylammoniumchlorid; Tetrapropylammoniumchlorid; Alkylbenzyldimethylammoniumchlorid; Alkylbenzyldimethylammoniumhydroxid; Natriumchlorit; Natriumhypochlorit; Isothiazolinonverbindung, die ausgewählt ist aus der Gruppe bestehend aus Methylisothiazolinon, Methylchlorisothiazolinon, Benzisothiazolinon und Kombinationen davon; und Kombinationen davon; und/oder der pH-Regulator ausgewählt ist aus der Gruppe bestehend aus anorganischer Säure, Salpetersäure, Sulfonsäure oder Phosphorsäure; anorganischer Base ausgewählt aus der Gruppe bestehend aus Ammoniumhydroxid, Kaliumhydroxid oder Natriumhydroxid; und organischer Base ausgewählt aus der Gruppe bestehend aus quaternärem Ammoniumhydroxid und Aminverbindung.

5. Zusammensetzung für die Reinigung nach CMP nach Anspruch 1, wobei es sich bei der Fluoridverbindung um Ammoniumfluorid handelt.

6. Zusammensetzung für die Reinigung nach CMP nach Anspruch 1, wobei das wasserlösliche Polymer oder Copolymer ausgewählt ist aus der Gruppe bestehend aus Acrylsäure-Acrylamidopropan-sulfonsäure-Copolymer, Poly(acrylsäure), Poly(meth-acrylsäure), Poly(2-acrylamido-2-methyl-1-propansulfonsäure), Carboxymethylcellulose, Methylcellulose, Hydroxypropylmethylcellulose, Poly-(1-vinylpyrroliddon-co-2-dimethylaminoethyl-methacrylat), Poly(natrium-4-styrolsulfonat), Poly(ethylenoxid), Poly(4-styrolsulfonsäure), Polyacrylamid, Poly(acrylamid/acrylsäure)-Copolymer und Kombinationen davon; wobei das Molekulargewicht des wasserlöslichen Polymers oder Copolymers im Bereich von 100 bis 10.000.000 liegt.

7. Zusammensetzung für die Reinigung nach CMP nach Anspruch 1, wobei die Zusammensetzung eine Trübung von weniger als 2,5 NTU, vorzugsweise 2 NTU oder stärker bevorzugt 1 NTU aufweist.

8. Zusammensetzung für die Reinigung nach CMP nach Anspruch 1, wobei die Zusammensetzung mindestens eine organische Säure, die ausgewählt ist aus der Gruppe bestehend aus Oxalsäure, Zitronensäure, Malonsäure und Kombinationen davon; und gegebenenfalls die Fluoridverbindung, die ausgewählt ist aus der Gruppe bestehend aus Fluorwasserstoffsäure, Ammoniumfluorid, Ammoniumbifluorid, quaternären Ammoniumfluoriden und Kombinationen davon; und gegebenenfalls das wasserlösliche Polymer enthaltend eine Acrylsäuregruppe oder das wasserlösliche Copolymer enthaltend Monomere mit einer Acrylsäuregruppe enthält.

9. Verfahren für die Reinigung nach chemisch-mechanischer Planarisierung (CMP) von einem Halbleiterwafer mit mindestens einer Oberfläche, die ausgewählt ist aus der Gruppe bestehend aus metallischem Film, dielektrischem Film und Kombinationen davon, umfassend:
Bereitstellen des Halbleiterwafers;
Bereitstellen der Zusammensetzung für die Reinigung nach chemisch-mechanischer Planarisierung (CMP) nach irgendeinem der Ansprüche 1 bis 8; und
Reinigen des Halbleiterwafers mit der Zusammensetzung für die Reinigung nach CMP; wobei der metallische Film ausgewählt ist aus der Gruppe bestehend aus Wolfram, Kupfer, Cobalt, Ruthenium, Aluminium und Kombinationen davon.

10. Verfahren für die Reinigung nach chemisch-mechanischer Planarisierung (CMP) nach Anspruch 9, bei dem das Verfahren metallische Rückstände ausgewählt aus der Gruppe bestehend aus Fe, W, Ti, TiN und Kombinationen davon von der mindestens einen Oberfläche entfernt.

11. Verfahren für die Reinigung nach chemisch-mechanischer Planarisierung (CMP) nach Anspruch 9, wobei die Zusammensetzung am Einsatzort 2- bis 500-fach mit Wasser verdünnt wird.

12. System für die Reinigung nach chemisch-mechanischer Planarisierung (CMP) eines Halbleiterwafers mit mindestens einer Oberfläche, die ausgewählt ist aus der Gruppe bestehend aus metallischem Film, dielektrischem Film und Kombinationen davon, umfassend:
den Halbleiterwafer; und
die Zusammensetzung für die Reinigung nach chemisch-mechanischer Planarisierung (CMP) nach irgendeinem der Ansprüche 1 bis 8; und
wobei die mindestens eine Oberfläche mit der Zusammensetzung für die Reinigung nach CMP in Kontakt steht und der metallische Film ausgewählt ist aus der Gruppe bestehend aus Wolfram, Kupfer, Cobalt, Ruthenium, Aluminium und Kombinationen davon.

## Revendications

1. Composition de nettoyage post-Planarisation Chimico-Mécanique (CMP) comprenant :
au moins un acide organique choisi dans le groupe constitué par l'acide oxalique, l'acide citrique, l'acide maléique, l'acide malique, l'acide malonique, l'acide gluconique, l'acide glutarique, l'acide ascorbique, l'acide formique, l'acide acétique, l'acide éthylènediamine-tétraacétique, l'acide diéthylènetriaminepentaacétique, la glycine, l'α-alanine, la cystine, et des combinaisons de celui-ci ou ses sels ;
au moins deux agents tensioactifs ;
où au moins l'un parmi les au moins deux agents tensioactifs est un premier type d'agent tensioactif ayant au moins deux groupements acide sulfonique ; et au moins l'un parmi les au moins deux agents tensioactifs est un deuxième type d'agent tensioactif qui n'est pas le premier type d'agent tensioactif ;
et
de l'eau ;
éventuellement :
un composé de fluorure ;
un polymère ou copolymère hydrosoluble ;
un inhibiteur de corrosion ;
un conservateur biologique ; et
un agent d'ajustement du pH,
la composition ayant un pH allant de 1 à 7 ; préférablement 2 à 6, ou plus préférablement de 3 à 6 ; et
le premier type d'agent tensioactif est un acide diphényldisulfonique ou son sel ; le deuxième type d'agent tensioactif comprenant un acide alcane sulfonique secondaire ayant une chaîne hydrophobe en C₁₂-C₁₇.

2. Composition de nettoyage post-CMP selon la revendication 1, dans laquelle le premier type d'agent tensioactif présente une structure choisie dans le groupe constitué par : 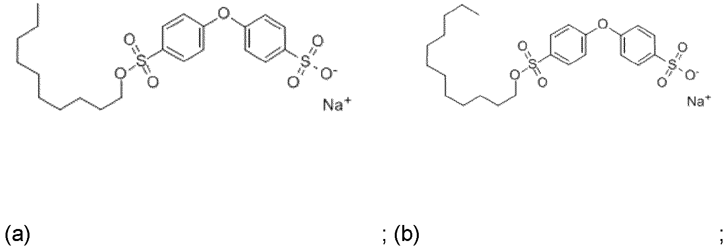 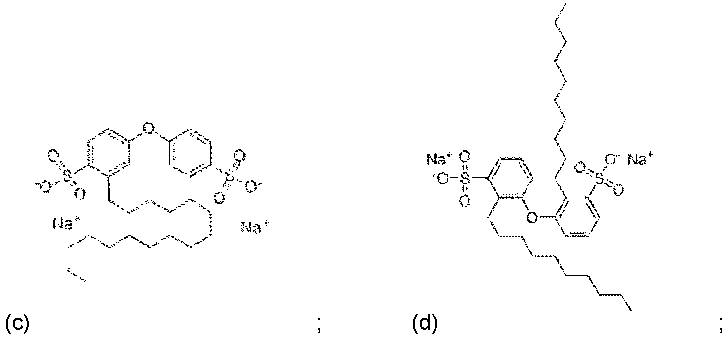 et

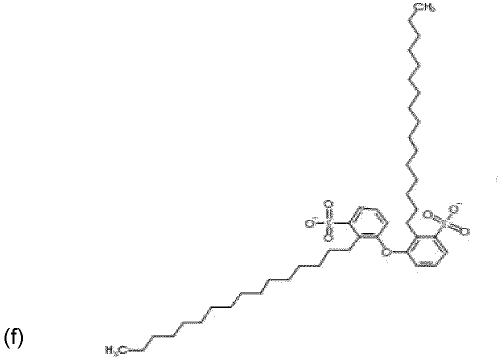

3. Composition de nettoyage post-CMP selon la revendication 1, dans laquelle le deuxième type d'agent tensioactif présente une tension superficielle < 50 dynes/cm, préférablement <45 dynes/cm à une concentration de 0,01% en poids dans l'eau.

4. Composition de nettoyage post-CMP selon la revendication 1, dans laquelle le composé de fluorure est choisi dans le groupe constitué par l'acide fluorhydrique, le fluorure d'ammonium, le bifluorure d'ammonium, les fluorures d'ammonium quaternaire, et des combinaisons de ceux-ci ; le polymère hydrosoluble comprend un groupement choisi dans le groupe constitué par un groupement acide sulfonique, un groupement acide acrylique, et des combinaisons de ceux-ci ; et le copolymère hydrosoluble comprend des monomères ayant un groupement choisi dans le groupe constitué par un groupement acide sulfonique, un groupement acide acrylique, et des combinaisons de ceux-ci ;
l'inhibiteur de corrosion est choisi dans le groupe constitué par un oligomère ou polymère comprenant de l'éthylèneimine, de la propylèneimine, de la polyéthylèneimine (PEI), et des combinaisons de celles-ci ; où le poids moléculaire de l'oligomère ou du polymère se trouve dans la plage comprise entre 500 et 15 000 ;
le conservateur biologique est choisi dans le groupe constitué par : le chlorure de tétra-méthylammonium ; le chlorure de tétraéthylammonium ; le chlorure de tétrapropylammo-nium ; le chlorure d'alkylbenzyldiméthylammonium ; l'hydroxyde d'alkylbenzyldiméthylammonium ; le chlorite de sodium ; l'hypochlorite de sodium ; un composé d'isothiazolinone choisi dans le groupe constitué par la méthylisothiazolinone, la méthylchloroisothiazolinone, la benzisothiazolinone et des combinaisons de celles-ci ; et des combinaisons de ceux-ci ; et/ou l'agent d'ajustement du pH est choisi dans le groupe constitué par un acide inorganique, l'acide nitrique, l'acide sulfonique, ou l'acide phosphorique ; une base inorganique choisie dans le groupe constitué par l'hydroxyde d'ammonium, l'hydroxyde de potassium ou l'hydroxyde de sodium ; et une base organique choisie dans le groupe constitué par un hydroxyde d'ammonium quaternaire, et un composé d'amine.

5. Composition de nettoyage post-CMP selon la revendication 1, dans laquelle le composé de fluorure est le fluorure d'ammonium.

6. Composition de nettoyage post-CMP selon la revendication 1, dans laquelle le polymère ou copolymère hydrosoluble est choisi dans le groupe constitué par un copolymère d'acide acrylique-acide acrylamidopropanesulfonique, le poly(acide acrylique), le poly(acide méthacrylique), le poly(acide 2-acrylamido-2-méthyl-1-propanesulfonique), la carboxyméthylcellulose, la méthylcellulose, l'hydroxypropyl méthylcellulose, le poly-(méthacrylate de 1-vinylpyrroliddone-co-2-diméthylaminoéthyle), le poly(4-styrène-sulfonate de sodium), le poly(oxyde d'éthylène), le poly(acide 4-styrènesulfonique), le polyacrylamide, un copolymère de poly(acrylamide/acide acrylique), et des combinaisons de ceux-ci ; où le poids moléculaire du polymère ou copolymère hydrosoluble va de 100 à 10 000 000.

7. Composition de nettoyage post-CMP selon la revendication 1, la composition présentant une turbidité inférieure à 2,5 NTU, préférablement 2 NTU, ou plus préférablement 1 NTU.

8. Composition de nettoyage post-CMP selon la revendication 1, la composition comprenant au moins un acide organique choisi dans le groupe constitué par l'acide oxalique, l'acide citrique, l'acide malonique, et des combinaisons de ceux-ci ; et éventuellement le composé de fluorure est choisi dans le groupe constitué par l'acide fluorhydrique, le fluorure d'ammonium, le bifluorure d'ammonium, les fluorures d'ammonium quaternaire, et des combinaisons de ceux-ci ; et éventuellement le polymère hydrosoluble comprenant un groupement acide acrylique ou le copolymère hydrosoluble comprenant des monomères ayant un groupement acide acrylique.

9. Méthode de nettoyage post-Planarisation Chimico-Mécanique (CMP) d'une plaquette semi-conductrice comprenant au moins une surface choisie dans le groupe constitué par un film métallique, un film diélectrique, et des combinaisons de ceux-ci, comprenant :
la mise à disposition de la plaquette semi-conductrice ;
la mise à disposition de la composition de nettoyage post-Planarisation Chimico-Mécanique (CMP) selon l'une quelconque des revendications 1 à 8 ; et
le nettoyage de la plaquette semi-conductrice à l'aide de la composition de nettoyage post-CM P ;
dans laquelle le film métallique est choisi dans le groupe constitué par le tungstène, le cuivre, le cobalt, le ruthénium, l'aluminium, et des combinaisons de ceux-ci.

10. Méthode de nettoyage post-Planarisation Chimico-Mécanique (CMP) selon la revendication 9, la méthode éliminant les résidus métalliques choisis dans le groupe constitué par Fe, W, Ti, TiN et des combinaisons de ceux-ci, à partir de la au moins une surface.

11. Méthode de nettoyage post-Planarisation Chimico-Mécanique (CMP) selon la revendication 9, la composition étant diluée par de l'eau de 2 à 500 fois au point d'utilisation.

12. Système de nettoyage post-Planarisation Chimico-Mécanique (CMP) de plaquettes semiconductrices comprenant au moins une surface choisie dans le groupe constitué par un film métallique, un film diélectrique, et des combinaisons de ceux-ci, comprenant :
la plaquette semi-conductrice ; et
la composition de nettoyage post-Planarisation Chimico-Mécanique (CMP) selon l'une quelconque des revendications 1 à 8 ; et
dans lequel la au moins une surface est en contact avec la composition de nettoyage post-CMP et le film métallique est choisi dans le groupe constitué par le tungstène, le cuivre, le cobalt, le ruthénium, l'aluminium, et des combinaisons de ceux-ci.
